# EUROPÄISCHE PATENTSCHRIFT

(11) **EP 0 432 150 B1**
(45) Veröffentlichungstag und Bekanntmachung des Hinweises auf die Patenterteilung: **27.01.1993**
(21) Anmeldenummer: 88903178.7
(22) Anmeldetag: 18.04.1988
(51) Int. Cl.: H01S 3/19, H01S 3/06, H01S 3/25, H01L 33/00

(54) **LASERDIODE MIT VERGRABENER AKTIVER SCHICHT UND SEITLICHER STROMBEGRENZUNG UND VERFAHREN ZU DEREN HERSTELLUNG**
LASER DIODE WITH BURIED ACTIVE LAYER AND LATERAL CURRENT LIMITING AND PROCESS FOR ITS MANUFACTURE
DIODE A LASER A COUCHE ACTIVE ENSEVELIE ET LIMITATION LATERALE DE COURANT ET SON PROCEDE DE PRODUCTION

(30) Priorität: 16.04.1987 DE 3713133; 16.04.1987 DE 3713045
(43) Veröffentlichungstag der Anmeldung: 19.06.1991
(73) Patentinhaber: SIEMENS AKTIENGESELLSCHAFT, 80333 München (DE)
(72) Erfinder: THULKE, Wolfgang, D-8000 München 83 (DE)
(86) Internationale Anmeldenummer: DE8800234
(87) Internationale Veröffentlichungsnummer: WO8808215

(56) Entgegenhaltungen:
- EP-A- 0 206 851
- EP-A- 0 208 209
- GB-A- 2 156 584
- IEEE Journal of Quantum Electronics, Band QE-21, Nr. 6, Juni 1985, Seiten 650 - 657
- IEEE Journal of Quantum Electronics, Band QE-16, Nr. 2, Februar 1980, IEEE (New York, US), Katsumi Kishino et al.: "Fabrication and lasing properties of mesa substrate buried heterostructure GaInAsP/InP lasers at 1.3 m wavelength", Seiten 160-164; siehe Kapitel I, IIA, IIB; Figuren 1,2
- Patent Abstracts of Japan, Band 11, Nr. 46 (E-479)(2493), 12. Februar 1987 & JP, A, 61208886 (NEC CORP.) 17. September 1986
- IEEE Journal of Quantum Electronics, Band OE-22, Nr. 6, Juni 1986, IEEE (New York, US), J.E. Bowers et al.: "High-speed InGaAsP constricted-mesa lasers", Seiten 833-843

## Beschreibung

Die Erfindung betrifft eine Laserdiode mit vergrabener aktiver Schicht und seitlicher Strombegrenzung und ein Verfahren zu deren Herstellung. Der Obergriff des Anspruches 1 entspricht dem aus den Dokumenten IEEE Journal of Quantum Electronics, Bd. QE-22, Nr.6, Juni 1986, Seiten 833-843, und EP-A-0208209 hervorgehenden Stand der Technik.

Es ist bekannt, Laserdioden mit niedrigem schwellenstrom und hohem differentiellem Wirkungsgrad auch bei hoher Ausgangsleistung als Vergrabene-Doppelheterostruktur-Laser (buried heterostructure laser, BH-Laser) herzustellen. (siehe z. B. G. Winstel, C. Weyrich, Optoelektronik 1, Springer Verlag, Berlin, Heidelberg, New York 1980, Seite 225 bis 232). Die aktive Schicht dieser Laser wird in Form eines schmalen Streifens in ein Halbleitermaterial mit geringerer Brechzahl und größerer Energiebandlücke eingebettet. Die Doppelheterostruktur und die Einbettung der aktiven Schicht sorgen für einen niedrigen Schwellenstrom und für eine Führung der Strahlung in transversaler und lateraler Richtung, so daß die Verluste der Laserleistung durch Beugung in passive Bereiche gering gehalten werden. Durch seitliche Strombegrenzung möglichst auf das schmale Gebiet der aktiven Schicht wird der Wirkungsgrad erhöht. Bei unvollkommener seitlicher Strombegrenzung, z. B. nur durch die unterschiedlichen Einsatzspannungen des Hetero-p-n-Überganges und des Homo-p-n-Überganges, fließt ein Nebenschlußstrom außerhalb der aktiven Schicht, und es wird keine hohe Ausgangsleistung erreicht. Durch zusätzliche, in Sperrichtung gepolte p-n-Übergänge, seitlich des aktiven Streifens sind hohe Ausgangsleistungen erzielbar. Die p-n-Übergänge stellen jedoch zusätzliche parasitäre Kapazitäten dar, die das Modulationsverhalten der Laserdiode beeinträchtigen.

Es ist bekannt, Nebenschlußströme und parasitäre Kapazitäten dadurch zu verringern, daß die wirksamen Flächen der entsprechenden p-n-Übergänge verringert werden. Dies geschieht z. B. durch Abätzen der entsprechenden Schichten oder dadurch, daß diese Schichten durch Ätzen von Kanälen vom stromführenden Gebiet getrennt werden. Die daraus resultierenden Strukturen sind nicht planar, was für die Herstellung und spätere Montage ungünstig ist.

In der Druckschrift von H. Burkhard und E. Kuphal: "Three- and Four-Layer LPE InGaAs(P) Mushroom Stripe Lasers for lambda= 1.30, 1.54, and 1.66 µm" in IEEE Journal of Quantum Electronics QE-21, 650 bis 657 (1985) wird ein Laseraufbau beschrieben, bei dem seitlich des aktiven Streifens Kanäle in das Halbleitermaterial geätzt sind. Bei diesem Aufbau wird eine Mesa auf die Substratoberfläche geätzt und anschließend am unteren Rand dieser Mesa durch seitlichen Angriff einer Ätze Kanäle seitlich eines aktiven Streifens ausgeätzt. Die Abmessung und seitliche Begrenzung des aktiven Streifens wird durch den Ätzprozeß bestimmt. Die Kanäle werden anschließend mit Phosphorsilikatglas aufgefüllt.

Eine weitere Möglichkeit zur Verringerung der wirksamen Flächen ist, den spezifischen Widerstand des Halbleitermaterials außerhalb des stromführenden Bereichs, z. B. durch Implantation von Protonen, zu erhöhen. Die erreichbaren Werte werden durch die erzielbare Erhöhung des Widerstands begrenzt. Ein Nachteil dieser Methode ist, daß der Widerstand sich durch Ausheilen der Kristallstruktur unter Wärmeeinfluß wieder verringern kann.

Aufgabe der vorliegenden Erfindung ist, eine einfach herzustellende BH-Laserdiode mit niedrigem Schwellenstrom und hohem differenziellen Wirkungsgrad auch bei hoher Ausgangsleistung in planarer Struktur und ein Verfahren zu deren Herstellung anzugeben.

Diese Aufgabe wird mit einer Laserdiode mit den Merkmalen des Anspruchs 1 und dem Verfahren nach Anspruch 11, 13 und 15 gelöst.

Weitere Ausgestaltungen der Erfindung gehen aus den Unteransprüchen hervor.

Der erfindungsgemäße Aufbau der Laserdiode enthält eine Schichtstruktur, die es ermöglicht, laterale Kanäle parallel zu dem Streifen der aktiven Schicht auszuätzen und gleichzeitig den aktiven Streifen in der durch die Maskentechnik vorgegebenen geradlinigen Begrenzung zu lassen. Der Gedanke ist dabei, den aktiven Streifen so in Halbleitermaterial einzubetten, daß die Herstellung der lateralen Kanäle zur seitlichen Strombegrenzung erfolgen kann, ohne daß Gefahr besteht, daß der jeweilige aktive Streifen beim Ausätzen der Kanäle mit angeätzt wird. Außerdem soll sichergestellt sein, daß sich diese Laserdiode leicht reproduzieren läßt und dabei durch eine geeignete Maskentechnik zum Beispiel der laseraktive Streifen in seinen Abmessungen und seiner Ausgestaltung festgelegt ist und durch den nachfolgenden Ätzschritt nicht mehr verändert werden kann. Die Erfindung wird im folgenden anhand einiger Ausführungsbeispiele und der zugehörigen Herstellungsverfahren beschrieben.
- Fig. 1: zeigt ein Ausführungsbeispiel einer erfindungsgemäßen Laserdiode mit Spacerschichten.
- Fig. 2: zeigt den Aufbau nach dem ersten Epitaxiezyklus bei der Herstellung der in Fig. 1 dargestellten Laserdiode.
- Fig. 3: zeigt den Aufbau nach dem sich an den ersten Epitaxiezyklus anschließenden Ätzschritt bei der Herstellung der in Fig. 1 dargestellten Laserdiode.
- Fig. 4: zeigt den Aufbau nach dem zweiten Epitaxiezyklus bei der Herstellung der in Fig. 1 dargestellten Laserdiode.
- Fig. 5: zeigt den Aufbau nach dem sich an den ersten Epitaxiezyklus anschließenden Ätzschritt bei der Herstellung der in Fig. 7 dargestellten Laserdiode.
- Fig. 6: zeigt den Aufbau nach dem zweiten Eptiaxiezyklus bei der Herstellung der in Fig. 7 dargestellten Laserdiode.
- Fig. 7: zeigt ein Ausführungsbeispiel einer erfindungsgemäßen Laserdiode mit Spacerschichten aus demselben Material wie die Deckschicht.
- Fig. 8: zeigt den Aufbau vor dem Ätzen der lateralen Kanäle bei der Herstellung der in Fig. 10 dargestellten Laserdiode.
- Fig. 9: zeigt einen zur Fig. 8 alternativen Aufbau.
- Fig. 10: zeigt ein Ausführungsbeispiel einer erfindungsgemäßen Laserdiode mit strukturiertem Substrat.
- Fig. 11: zeigt ein weiteres Ausführungsbeispiel einer erfindungsgemäßen Laserdiode mit strukturiertem Substrat.
- Fig. 12: zeigt ein Ausführungsbeispiel einer erfindungsgemäßen Laserdiode mit strukturiertem Substrat aus semiisolierendem Material.

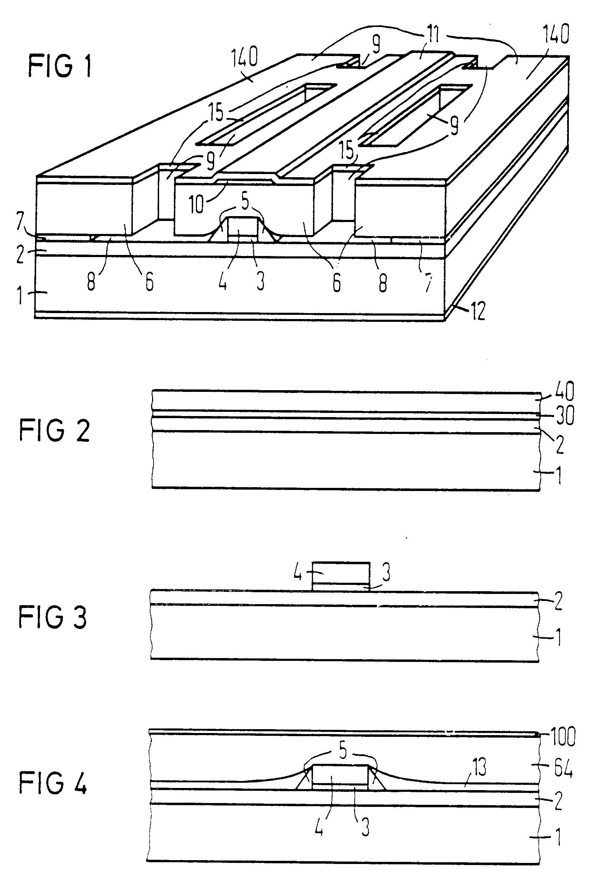

Es folgt die Beschreibung der Erfindung anhand des in Fig. 1 dargestellten Ausführungsbeispiels.

Auf ein Substrat 1 aus einem ersten Halbleitermaterial, z.B. InP, eines ersten Leitfähigkeitstyps folgt eine Pufferschicht 2 aus dem gleichen Material des ersten Leitfähigkeitstyps. Auf der Pufferschicht 2 ist eine streifenförmige aktive Schicht 3 aufgewachsen, die z.B. aus InGaAsP besteht. Dieser aktive Streifen 3 ist undotiert oder vom ersten oder von einem zweiten Leitfähigkeitstyp. Der aktive Streifen 3 ist von allen Seiten von Schichten aus dem ersten Halbleitermaterial, hier z.B. InP, umgeben.

Auf dem aktiven Streifen 3 ist ein oberer Streifen 4 aus dem ersten Halbleitermaterial, z.B. InP, eines zweiten Leitfähigkeitstyps aufgewachsen. Dieser obere Streifen 4 hat dieselbe Breite wie der aktive Streifen 3. Die Flanken des aktiven Streifens 3 und des oberen Streifens 4 sind von Spacerschichten 5 aus dem ersten Halbleitermaterial, z.B. InP, bedeckt. Diese Spacerschichten 5 sind so dotiert, daß ihr spezifischer Widerstand hoch ist. Damit ist sichergestellt, daß der elektrische Strom im wesentlichen über den aktiven Streifen 3 fließt. Die Spacerschichten 5 sorgen für eine seitliche Führung der Lichtwelle im Resonator der Laserdiode. Die Spacerschichten 5 können rechteckigen oder dreieckigen Querschnitt haben. Für die Strombegrenzung ist es günstig, die Spacerschichten 5 mit dreieckigem Querschnitt auszubilden. Es ist dann gewährleistet, daß der aktive Streifen 3 seitlich ganz bedeckt ist und daß gleichzeitig der Querschnitt, über den ein möglicher Nebenschlußstrom fließen kann, gering ist. Die Spacerschichten 5 berühren mit einer Kathete die Pufferschicht 2 und mit der anderen Kathete den aktiven Streifen 3 und den oberen Streifen 4. Die Spacerschichten 5 reichen nicht über die Oberkante des oberen Streifens 4 hinaus.

Auf den oberen Streifen 4 folgt ganzflächig eine Deckschicht 6 aus dem ersten Halbleitermaterial, z.B. InP, vom zweiten Leitfähigkeitstyp. Diese Deckschicht 6 ist mit der Pufferschicht 2 beiderseits des aktiven Streifens 3 durch Stege 7, die z.B. aus InGaAsP bestehen, verbunden. Zwischen der Deckschicht 6 und der Pufferschicht 2 verlaufen laterale Kanäle 8. Die lateralen Kanäle 8 verlaufen beiderseits des aktiven Streifens 3 zwischen den Spacerschichten 5 und den Stegen 7. Senkrecht zum Schichtaufbau sind in der Deckschicht 6 tranversale Kanäle 9 vorhanden. Die transversalen Kanäle 9 haben eine Verbindung mit den lateralen Kanälen 8.

Oberhalb des aktiven Streifens 3 folgt auf die Deckschicht 6 ein hochdotierter Kontaktstreifen 10 aus z.B. InGaAs oder InGaAsP vom zweiten Leitfähigkeitstyp. Dieser Kontaktstreifen 10 ist oberhalb des aktiven Streifens 3 verlaufend angeordnet. Über dem Kontaktstreifen 10 und der Deckschicht 6 folgt ein strukturierter Metallkontakt 11. Dieser strukturierte Metallkontakt 11 bedeckt den Kontaktstreifen 10 und die Deckschicht 6 ganz und besitzt Aussparungen 15 im Bereich der transveralen Kanäle 9. Außerhalb der transversalen Kanäle 9 ist eine Verbindung der mittleren und äußeren Strukturen des strukturierten Metallkontaktes 11 vorhanden. Dadurch kann die Laserdiode auf Kontaktierflächen 140 seitlich des Bereichs des Kontaktstreifens 10 kontaktiert werden. Auf der dem Schichtaufbau abgewandten Seite des Substrats 1 ist ein großflächiger weiterer Metallkontakt 12 angebracht.

Der hochdotierte Kontaktstreifen 10 ist grundsätzlich entbehrlich; er verringert aber den Kontaktwiderstand im Bereich des aktiven Streifens 3 wesentlich und erzeugt dadurch eine zusätzliche seitliche Strombegrenzung. Diese seitliche Strombegrenzung kann noch verbessert werden, indem eine Oxidschicht außerhalb des von diesem Kontaktstreifen 10 eingenommenen Bereiches auf der Deckschicht 6 abgeschieden wird und auf diese Oxidschicht erst der strukturierte Metallkontakt 11 folgt. Es ist ein wesentlicher Vorteil, daß die transversalen Kanäle 9 einen relativ geringen Bereich der Oberfläche einnehmen und daß der strukturierte Metallkontakt 11 ganzflächig auf Halbleiterschichten aufgebracht ist. Die durch die transversalen Kanäle 9 bedingten Aussparungen 15 sind relativ klein, so daß sich große Kontaktierflächen 140 ergeben, die eine Kontaktierung außerhalb des Bereichs der aktiven Streifen 3 ermöglichen. Eine Kontaktierung im Bereich von aktiven Streifen 3 wirkt sich ungünstig auf das Modulationsverhalten einer Laserdiode aus.

Die Spacerschichten 5 werden aus einem Halbleitermaterial hergestellt, daß niedrig dotiert ist und von der Ätze, die für das Ausätzen der Kanäle verwendet wird, nicht angegriffen wird.

Mit Hilfe von Fig. 2 bis Fig. 4 wird die Herstellung der in Fig. 1 dargestellten Laserdiode erläutert.

Auf das Substrat 1 aus z.B. InP eines ersten Leitfähigkeitstyps werden die Pufferschicht 2 aus z.B. InP des ersten Leitfähigkeitstyps, eine aktive Schicht 30 aus z.B. InGaAsP und eine obere Schicht 40 aus z.B. InP eines zweiten Leitfähigkeitstyps aufgebracht (Fig. 2). Mit Hilfe einer Maske werden die aktive Schicht 30 und die obere Schicht 40 auf einen aktiven Streifen 3 und einen oberen Streifen 4 herabgeätzt (Fig. 3).

In einem weiteren Epitaxieschritt werden auf die Flanken des aktiven Streifens 3 und des oberen Streifens 4 seitliche Spacerschichten 5 aus z.B. InP aufgewachsen. Die Parameter in diesem Epitaxieschritt werden so gewählt, daß ihre Spacerschichten 5 hauptsächlich an den Flanken des aktiven Streifens 3 und des oberen Streifens 4 aufwachsen. Das Material der Spacerschichten 5 ist so dotiert, daß sein spezifischer Widerstand hoch ist. Auf die Flanken der Spacerschichten 5 und die Pufferschicht 2 wird beiderseits der Spacerschichten 5 eine Zwischenschicht 13 aus z.B. InGaAsP so aufgewachsen, daß sie höchstens bis an die Oberkante des oberen Streifens 4 heranreicht und daß sie die Oberseite des oberen Streifens 4 unbedeckt läßt.

Auf den oberen Streifen 4 und die Zwischenschicht 13 wird eine Deckschicht 64 aus z.B. InP vom zweiten Leitfähigkeitstyp aufgewachsen. Die Wachstumsparameter werden so gewählt, daß diese Deckschicht 64 den oberen Streifen 4 und die Zwischenschicht 13 bedeckt und daß die Oberfläche dieser Deckschicht 64 eben ist. Auf die Deckschicht 64 wird eine hochdotierte Kontaktschicht 100 aus z.B. InGaAs oder InGaAsP vom zweiten Leitfähigkeitstyp aufgewachsen (Fig. 4). Mit Hilfe einer Maske wird diese hochdotierte Kontaktschicht 100 auf einen Kontaktstreifen 10 herabgeätzt. Auf die Deckschicht 64 und den Kontaktstreifen 10 wird ein strukturierter Metallkontakt 11 aufgebracht. Der strukturierte Metallkontakt 11 ist so realisiert, daß er den Kontaktstreifen 10 ganz überdeckt, daß er auf beiden Seiten der Oberfläche ausserhalb des von dem Kontaktstreifen 10 eingenommenen Bereiches Kontaktierflächen 140 enthält, die mit dem den Kontaktstreifen 10 überdeckenden Teil leitend verbunden sind und daß er zwischen den Kontaktierflächen 140 und dem den Kontaktstreifen 10 überdeckenden Teil Aussparungen 15 aufweist, die die Oberfläche der Deckschicht 64 partiell freilegen.

Im nächsten Schritt wird der strukturierte Metallkontakt 11 als Maske beim Ätzen von transversalen Kanälen 9 in die Deckschicht 64 verwendet. Die transversalen Kanäle 9 werden bis auf die Zwischenschicht 13 geätzt. Durch die transversalen Kanäle 9 wird im folgenden Schritt mit einer selektiv wirksamen Ätze die Zwischenschicht 13 teilweise weggeätzt. Die zwischen der Deckschicht 6 und der Pufferschicht 2 durch Wegätzen der Zwischenschicht 13 erzeugten lateralen Kanäle 8 reichen bis an die Spacerschichten 5 heran. Die Spacerschichten 5 werden bei diesem Ätzprozeß nicht angegriffen; insbesondere bleibt auf diese Weise der aktive Streifen 3 unbeschädigt. Die Zwischenschicht 13 wird bis an die Spacerschichten 5 und die Oberkante des oberen Streifens 4 weggeätzt. An den Seiten der Laserdiode bilden Reste der Zwischenschicht 13 die Stege 7, durch die die Deckschicht 6 mit der Pufferschicht 2 verbunden ist (Fig. 1). Auf der dem Schichtaufbau abgewandten Seite des Substrats 1 wird ein großflächiger weiterer Metallkontakt 12 aufgebracht.

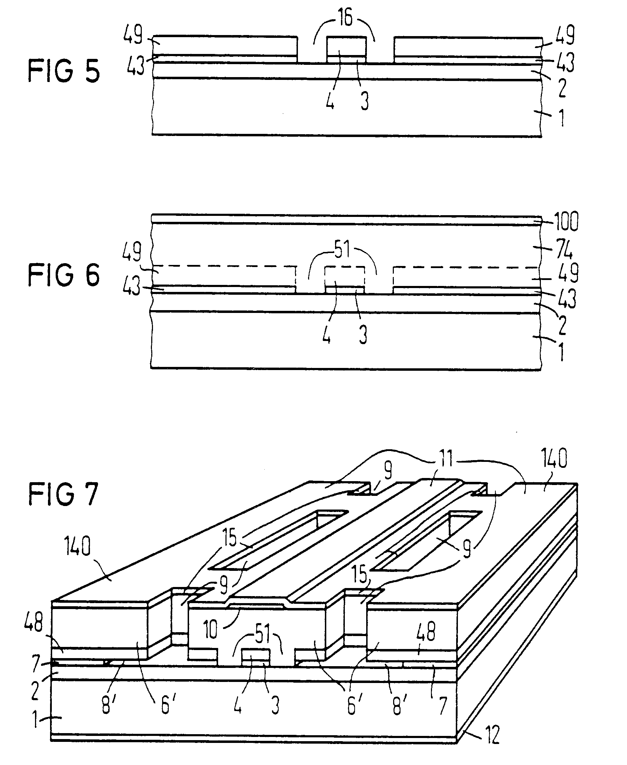

Die Herstellung eines weiteren, in Fig. 7 dargestellten Ausführungsbeispieles der erfindungsgemäßen Laserdiode wird mit Hilfe von Fig. 5 bis 7 erläutert. Damit ergibt sich gleichzeitig eine Beschreibung des Aufbaus der fertigen Laserdiode.

Das Herstellungsverfahren geht von der in Fig. 2 dargestellten Grundstruktur aus, die ein Substrat 1 aus z.B. InP des ersten Leitfähigkeitstyps, eine Pufferschicht 2 aus z.B. InP des ersten Leitfähigkeitstyps, eine aktive Schicht 30 aus z.B. InGaAsP und eine obere Schicht 40 aus z.B. InP des zweiten Leitfähigkeitstyps enthält. Mit Hilfe einer Maske werden parallele Gräben 16 in die obere Schicht 40 und die aktive Schicht 30 bis auf die Pufferschicht 2 so geätzt, daß zwischen ihnen ein aktiver Streifen 3 aus der aktiven Schicht 30 und darauf ein oberer Streifen 4 aus der oberen Schicht 40 stehen bleiben und daß außerhalb der parallelen Gräben 16 Seitenbereiche 43 der aktiven Schicht 30 und Seitenbereiche 49 der oberen Schicht 40 stehenbleiben (Fig. 5).

Im folgenden Schritt wird die Struktur mit einer Deckschicht 74 bedeckt, wobei die parallelen Gräben 16 mit Spacerschichten 51 aufgefüllt und diese zusammen mit den oberen Streifen 4 und den entsprechenden Seitenbereichen 49 mit dieser Deckschicht 74 überwachsen werden. Die Deckschicht 74 besteht z.B. InP vom zweiten Leitfähigkeitstyp. Auf die Deckschicht 74 wird eine hochdotierte Kontaktschicht 100 aufgewachsen (Fig. 6), die z.B. aus InGaAs oder InGaAsP vom zweiten Leitfähigkeitstyp besteht.

Diese hochdotierte Kontaktschicht 100 wird mit Hilfe einer Maske so zu einem Kontaktstreifen 10 herabgeätzt, daß dieser Kontaktstreifen 10 oberhalb des aktiven Streifens 3 verläuft und außerhalb des von diesem Kontaktstreifens 10 eingenommenen Bereiches die Deckschicht 6' freigelegt wird (Fig. 7). Im nächsten Schritt wird der Schichtaufbau der dem Substrat abgewandten Seite mit einem strukturierten Metallkontakt 11 versehen. Der strukturierte Metallkontakt 11 ist so gestaltet, daß er den Kontaktstreifen 10 ganz überdeckt, daß er außerhalb des von dem aktiven Streifen 3 und den Spacerschichten 51 eingenommenen Bereichs Aussparungen 15 aufweist und daß er eine Kontaktierung auf Kontaktierflächen 140 außerhalb des Bereichs des Kontaktstreifens 10 ermöglicht (Fig. 7).

Der strukturierte Metallkontakt 11 wird als Maske verwendet, um senkrecht zum Schichtaufbau verlaufende transversale Kanäle 9 in die Deckschicht 6' und die Seitenbereiche 49 der oberen Schicht 40 bis auf die Seitenbereiche 43 der aktiven Schicht 30 außerhalb des aktiven Streifens 3 und der Spacerschichten 51 zu ätzen. Durch diese transversalen Kanäle 9 hindurch werden mit einer selektiv wirksamen Ätze die Seitenbereiche 43 der aktiven Schicht 30 nach innen bis zu den Spacerschichten 51 hin weggeätzt. Dazu entstehen laterale Kanäle 8'. Die diese lateralen Kanäle 8' begrenzenden Stege 7 werden von den beim Ätzen verbleibenden Resten der Seitenbereiche 43 der aktiven Schicht 30 gebildet. Durch die Stege 7 sind die Seitenbereiche 48 der oberen Schicht 40 mit der Pufferschicht 2 verbunden (Fig. 7). Auf der dem Schichtaufbau abgewandten Seite des Substrates 11 wird die Laserdiode mit einem großflächigen weiteren Metallkontakt 12 versehen.

Der strukturierte Metallkontakt 11 und die transversalen Kanäle 9 vermindern die parasitären Kapazitäten, die im Betrieb der Laserdiode auftreten. Die lateralen Kanäle 8' sorgen für eine seitliche Strombegrenzung auf das Gebiet des aktiven Streifens 3. Die Qualität der Strombegrenzung hängt dabei von der Breite der Spacerschichten 51 ab. Das Material der Spacerschichten ist so beschaffen, daß es von der beim Ausätzen der lateralen Kanäle 8' verwendeten Ätze nicht angegriffen wird, so daß der aktive Streifen 3 seine ursprüngliche seitliche Begrenzung beibehält.

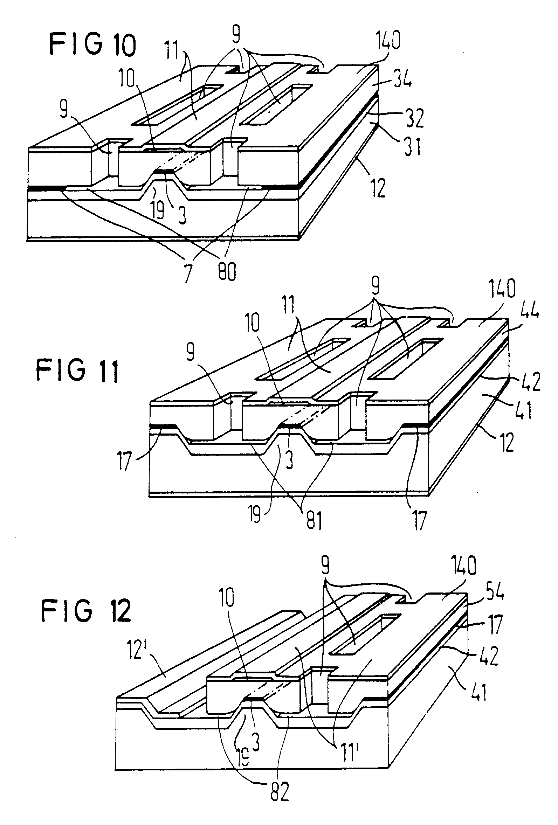

Gegenüber den bisher beschriebenen Ausführungsformen der erfindungsgemäßen Laserdiode haben die in den Fig. 10, 11 und 12 dargestellten Ausführungsformen den Vorteil, daß nur ein Epitaxiezyklus erforderlich ist. Bei der Herstellung in mehreren Epitaxieschritten werden die Grenzflächen, die durch Epitaxie in getrennten Prozessen mit zwischengeschalteter Strukturierung entstehen, wie z.B. die Grenzflächen des Laserstreifens, in ihrer Qualität beeinträchtigt. Aus diesem Grunde ist es empfehlenswert, BH-Laserdioden in nur einem Epitaxieschritt herzustellen. Die Herstellung von BH-Laserdioden in nur einem Epitaxiezyklus erfolgt unter Verwendung strukturierter Substrate. Beim Aufwachsen der aktiven Schicht werden die Wachstumsparameter so gewählt, daß die aktive Schicht auf der Struktur des Substrates und neben der Struktur, aber nicht auf deren Flanken aufwächst. Bei der erfindungsgemäßen Laserdiode muß das Substrat in der Weise strukturiert sein, daß die Flanken der Struktur bzw. das darauf aufgewachsene Halbleitermaterial eine natürliche Begrenzung für das Ausätzen von lateralen Kanälen als seitlicher Strombegrenzung dienen. Insbesondere muß sich das Material der aktiven Schicht von dem Material des Substrates bzw. der darauf aufgewachsenen Halbleiterschichten so unterscheiden, daß die Seitenbereiche der aktiven Schicht selektiv geätzt werden können. Bei diesem selektiven Ätzen darf das Material der Flanken der Strukturierung des Substrates nicht angegriffen werden, so daß sichergestellt ist, daß der aktive Streifen die durch die Strukturierung des Substrates gegebene Bemessung beibehält und durch das Ausbilden der lateralen Kanäle dessen seitliche Begrenzung nicht verändern wird.

Es folgt die Beschreibung der in den Fig. 10 bis 12 dargestellten Ausführungsbeispiele.

Auf einem strukturierten Substrat 31, 41 mit mindestens einem Ridge 19 ist die Pufferschicht 32, 42 aufgewachsen. Auf dem Ridge 19 verläuft der aktive Streifen 3. An den Rändern des Bauelementes verlaufen Stege 7, 17. Zwischen dem Ridge 19 mit dem aktiven Streifen 3 und den äußeren Stegen 7, 17 sind laterale Kanäle 80, 81, 82 ausgebildet. Die Laserdiode ist nach oben mit einer Deckschicht 34, 44, 54 planarisiert. Über dem aktiven Streifen 3 verläuft ein Kontaktstreifen 10 aus hochdotiertem Material zur Verminderung des Kontaktwiderstandes. Es sind auch hier transversale Kanäle 9 vorhanden, die so bemessen sind, wie für das Ausätzen der lateralen Kanäle 80, 81, 82 erforderlich ist, aber möglichst klein gehalten sind. Die gesamte Oberfläche der Halbleiterschichtfolge ist mit einem strukturierten Metallkontakt 11 bedeckt, der über den transversalen Kanälen 9 Aussparungen aufweist und außerhalb des von dem Kontaktstreifen 10 eingenommenen Bereiches Kontaktierflächen 140 aufweist.

Alle beschriebenen Ausführungsformen können mit einem Substrat aus semiisolierendem Material aufgebaut sein. In dem Fall ist nur die Pufferschicht 42 ganzflächig aufgewachsen. Außerhalb des von dem aktiven Streifen 3 und den für die seitliche Strombegrenzung erforderlichen Strukturelementen eingenommenen Bereiches ist zumindest auf einer Seite die Pufferschicht unmittelbar mit einem weiteren Metallkontakt 12' auf der Oberseite belegt. Es ist dann nur der von diesem weiteren Metallkontakt 12' nicht eingenommene Bereich der Oberfläche der Laserdiode mit der Deckschicht 57 planarisiert. Wenn das Substrat aus leitendem Material ist, wird der weitere Metallkontakt 12 ganzflächig auf der dem Schichtaufbau abgewandten Oberfläche des Substrates 31, 41 aufgebracht.

Einzelheiten des Aufbaues dieses Ausführungsbeispiels der erfindungsgemäßen Laserdiode gehen aus der folgenden Beschreibung des Herstellungsverfahrens hervor.

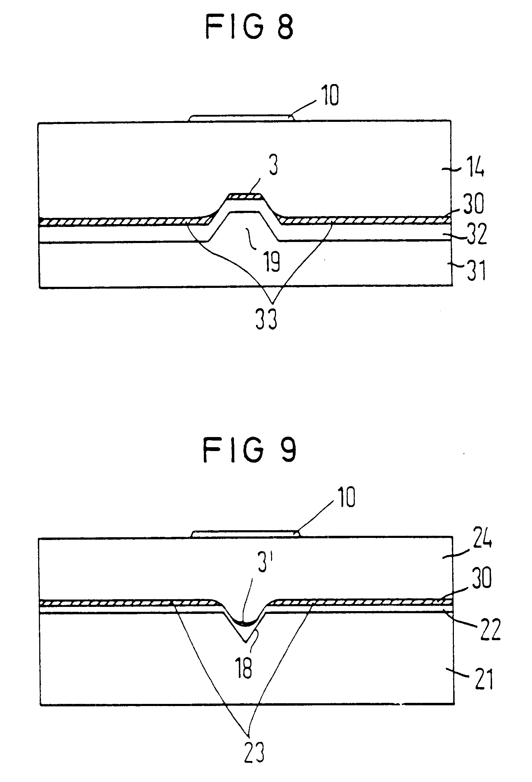

Es wird ein Substrat 21, 31 aus einem hochleitenden Halbleitermaterial, wie z.B. n-dotiertem InP, oder ein Substrat 41 aus einem semiisolierendem Halbleitermaterial, d.h. einem Halbleitermaterial mit hohem spezifischem Widerstand, verwendet. Durch Ätzen wird eine streifenförmige Struktur auf der Oberfläche des Substrates 21, 31 erzeugt. Diese Struktur kann in einem Gate 19 (Fig. 8) oder in einem Graben 18 (Fig. 9), der hier mit V-förmigem Querschnitt dargestellt ist, bestehen. Auf die in dieser Weise strukturierte Oberfläche des Substrats 21, 31 wird epitaktisch eine Pufferschicht 22, 32 aufgewachsen, die aus Halbleitermaterial des ersten Leitfähigkeitstyps, z.B. aus n-dotiertem InP, besteht. Dabei bleibt die Strukturierung des Substrates 21, 31 im wesentlichen erhalten. Auf diese Pufferschicht 22, 32 wird eine aktive Schicht 30 epitaktisch aufgewachsen. Diese aktive Schicht 30 besteht aus einem zweiten Halbleitermaterial mit geringerer Energiebandlücke und größerer Brechzahl als das Material der Pufferschicht 22, 32, z.B. aus InGaAsP. Die Abmessungen und Form der Substratstruktur sind so gewählt, daß bei entsprechender Wahl der Prozeßparameter die aktive Schicht 30 als aktiver Streifen 3, 3' auf der Strukturierung d.h. auf dem Gate 19 bzw. in dem Graben 18, und auf Seitenbereichen 23, 33 aufwächst. Auf den Flanken der Struktur gibt es streifenförmige Bereiche, in denen die Pufferschicht 22, 32 nicht von der aktiven Schicht 30 bedeckt ist. Die Seitenbereiche 23, 33 der aktiven Schicht 30 hängen also mit dem aktiven Streifen 3, 3' nicht zusammen. Durch geeignete Wahl der Wachstumsparameter zu erreichen, daß die aktive Schicht 30 wie oben beschrieben aufwächst, ist bei der Gasphasenepitaxie, der Molekularstrahlepitaxie wie bei der Flüssigphasenepitaxie. möglich.

Auf die aktive Schicht 30 wird epitaktisch eine Halbleiterschicht als Deckschicht 14, 24 aus dem gleichen Halbleitermaterial wie die Pufferschicht 22, 32 und vom zweiten Leitfähigkeitstyp, z.B. p-dotiertem InP, aufgewachsen. Dabei werden die Oberflächen der aktiven Schicht 30 und der auf den Flanken der Strukturierung nicht überwachsenen Pufferschicht 22, 32 vollständig bedeckt. Dadurch ergibt sich die für BH-Laser übliche Schichtstruktur mit Indexführung. Auf die Deckschicht 14, 24, die die Laserdiode planarisiert, wird eine Kontaktschicht aufgebracht und mit Hilfe einer Maske zu einem Kontaktstreifen 10, der oberhalb des aktiven Streifens 3, 3' verläuft, herabgeätzt. Dieser Kontaktstreifen 10 ist so hoch dotiert, daß er den Übergangswiderstand im Bereich des aktiven Streifens 3, 3' verringert. Es ergibt sich so der Aufbau nach Fig. 8 bzw. Fig. 9.

Es folgen die Verfahrensschritte, die von dem Teilaufbau nach Fig. 8 zu dem Aufbau von Fig. 10 führen: zunächst werden mit Hilfe einer Maske transversale Kanäle 9 außerhalb des von der Strukturierung des Substrates eingenommenen Bereiches in die Deckschicht 14 geätzt. Diese transversalen Kanäle 9 reichen mindestens bis auf die Seitenbereiche 33 der aktiven Schicht 30. Sie können aber auch bis in die Pufferschicht 32 hinein geätzt werden. Dieser Ätzschritt kann wie üblich naßchemisch oder durch Ionenätzen erfolgen. Durch diese transversalen Kanäle 9 hindurch werden durch teilweises Herausätzen der Seitenbereiche 33 der aktiven Schicht 30 mit einer selektiv wirksamen Ätze, die nur das Material der aktiven Schicht 30 anlöst und die das Material der Pufferschicht 32 und der Deckschicht 34 nicht angreift, seitlich des mit dem aktiven Streifen 3 überwachsenen ridge 19 laterale Kanäle 80 hergestellt. Diese lateralen Kanäle 80 sind seitlich durch die Flanken des ridge 19 und die als Stege 7 verbleibenden Reste der Seitenbereiche 33 der aktiven Schicht 30 begrenzt. An den Flanken des ridge 19 ist also die Pufferschicht 32 freigelegt. Die Breite der Stege 7 wird von der Ätzdauer bestimmt. Da das Material der Pufferschicht 32 und der Deckschicht 34 von der Ätze nicht angegriffen wird, kann das Ätzen soweit fortgesetzt werden, bis die Stege 7 die vorgegebene Breite erhalten. Der aktive Streifen 3 bleibt bei diesem Ätzprozeß unversehrt. Insbesondere bleiben die seitlichen Begrenzungen des aktiven Streifens 3 in dem bei dem Prozeß des Aufwachsens festgelegten Zustand.

Zur Vermeidung von Oberflächenströmen und zum Schutz der Halbleiteroberflächen vor mechanischen Beschädigungen ist es vorteilhaft, die Wände der lateralen Kanäle 80 und die Wände der transversalen Kanäle 9 mit einem elektrisch isolierenden Material, z.B. mit SiO₂, Al₂O₃ oder ähnlichem, zu beschichten. Es ist auch möglich, die lateralen Kanäle 80 und die transversalen Kanäle 9 mit einem elektrisch isolierenden Material aufzufüllen.

Schließlich wird auf die dem Schichtaufbau angewandte Seite des strukturierten Substrates 31 ein großflächiger weiterer Metallkontakt 12 aufgebracht. Auf die freie Oberfläche des Halbleiterschichtaufbaus wird ein strukturierter Metallkontakt 11 aufgebracht. Der strukturierte Metallkontakt 11 hat Aussparungen im Bereich der transversalen Kanäle 9 und ist so gestaltet, daß eine Kontaktierung der Laserdiode außerhalb des von dem Kontaktstreifen 10 eingenommenen Bereiches auf Kontaktierflächen 140 möglich ist. Es hat sich nämlich herausgestellt, daß es sich auf das Betriebsverhalten der Laserdiode ungünstig auswirkt, wenn die Laserdiode oberhalb des aktiven Streifens kontaktiert wird.

Fig. 11 zeigt ein Ausführungsbeispiel, bei dem die parallel zu dem den aktiven Streifen 3 tragenden ridge 19 verlaufenden Ränder des Substrates 41 gleichfalls mit solchen Graten versehen sind. Beim Aufwachsen der aktiven Schicht 30 ergeben sich so ein aktiver Streifen 3 auf dem mittleren ridge 19 und seitliche Stege 17 sowie die Seitenbereiche 33. Auf den jeweiligen Flanken der Strukturierung des Substrates 41 ist bzw. wird kein Material der aktiven Schicht 30 aufgewachsen. Dieser Aufbau hat den Vorteil, daß beim Ätzen der lateralen Kanäle 81 der Ätzprozeß so weit fortgesetzt werden kann, bis das gesamte Material der Seitenbereiche 33 der aktiven Schicht 30 weggeätzt ist. Dieser Aufbau ist besonders leicht vollständig reproduzierbar. Sowohl die Breite des aktiven Streifens 3 als auch die Breite der äußeren Stege 17 bleiben erhalten.

Bei der Herstellung der erfindungsgemäßen Laserdiode kann der strukturierte Metallkontakt 11 als Maske für das Ätzen der transversalen Kanäle 9 verwendet werden. Der strukturierte Metallkontakt 11 mit den entsprechenden Aussparungen wird dann vor dem Ätzen der transversalen Kanäle 9 auf die Deckschicht 14 aufgebracht. Der Aufbau der Laserdioden auf semiisolierendem Substrat 41 und Aufbringen beider Metallkontakte auf der Oberfläche der Schichtstruktur erleichtert die Integration der Laserdiode im größeren Baustein. Auch bei den zuletzt beschriebenen Ausführungsbeispielen ist es möglich, die seitiche Strombegrenzung durch Oxidschichten seitlich des Kontaktstreifens 10 zwischen der Deckschicht 34 und dem strukturierten Metallkontakt 11 zu verbessern. Die Herstellung der Laserdiode in nur einem Epitaxiezyklus ist von Vorteil im Hinblick auf die Lebensdauer.

Bei erfindungsgemäßen Ausführungsformen einer Laserdiode ist es wesentliche, daß eine seitliche Strombegrenzung durch laterale laufende Kanäle und eine seitliche Begrenzung des aktiven Streifens zum Schutz gegen die beim Ätzen verwendeten chemischen Stoffe vorgesehen sind. Es sind hier Ausführungsformen beschrieben, die jeweils einen laser aktiven Streifen enthalten. Selbstverständlich sind Ausführungsformen möglich, bei denen mehrere parallel zueinander verlaufende laseraktive Streifen, die gegebenenfalls miteinander verkoppelt sind, vorhanden sind und diese aktiven Streifen mit lateralen Kanälen jeweils im erfindungsgemäßen Aufbau versehen sind.

## Patentansprüche

1. Laserdiode mit vergrabener Halbleiter- Doppelheterostruktur und seitlicher Strombegrenzung, wobei diese Laserdiode mindestens einen laseraktiven Streifen (3) zwischen einer Pufferschicht (2,32,42) und einer Deckschicht (6,6',34,44,54) enthält und Metallkontakte aufweist und wobei seitlich des laser aktiven Streifens (3) und parallel zu diesem verlaufend laterale geätzte Kanäle (8,8',80,81,82) vorgesehen sind,
dadurch gekennzeichnet,
- daß der laser aktive Streifen (3) durch seitlich angeordnetes Halbleitermaterial von den lateralen Kanälen getrennt ist und
- daß die seitliche Begrenzung des laser aktiven Streifens (3) so geradlinig verläuft, wie dies bei unter Verwendung von Maskentechnik hergestellten Halbleiterschichten möglich ist.

2. Laserdiode nach Anspruch 1,
**dadurch gekennzeichnet,**
- daß das Halbleitermaterial, das seitlich an dem aktiven Streifen (3) angeordnet ist, als Spacerschichten (5,51) ausgebildet ist,
- daß in seitlich nach außen an diese Spacerschichten (5,51) angrenzend aufgewachsenem Halbleitermaterial die lateralen Kanäle (8,8') ausgebildet sind und
- daß die Spacerschichten (5,51) aus Halbleitermaterial bestehen, das von mindestens einem für selektives Ätzen der lateralen Kanäle (8,8') verwendbaren Stoff nicht angegriffen wird.

3. Laserdiode nach Anspruch 2,
**dadurch gekennzeichnet,**
daß auf einer Grundstruktur, die mindestens ein Substrat (1) und die Pufferschicht (2) aus einem ersten Halbleitermaterial enthält, der mindestens eine aktive Streifen (3) und darauf ein oberer Streifen (4) aufgebracht sind,
daß an die Flanken jedes aktiven Streifens (3) und des zugehörigen oberen Streifens (4) Spacerschichten (5,51) aufgebracht sind, die die Flanken des aktiven Streifens (3) jeweils vollständig bedecken,
daß seitlich an die Spacerschichten (5) angrenzend parallel zu dem aktiven Streifen (3) verlaufend laterale Kanäle (8,8') ausgebildet sind,
daß diese lateralen Kanäle (8,8') nach außen durch Stege (7) begrenzt sind,
daß die Laserdiode mit der Deckschicht (6,6') planarisiert ist,
daß oberhalb des eines aktiven Streifens (3) ein Kontaktstreifen (10) aufgebracht ist und
daß die Oberfläche dieses Kontaktstreifens (10) und der Deckschicht (6,6') mit einem strukturierten Metallkontakt (11), der mindestens eine Kontaktierfläche (140) außerhalb des von dem Kontaktstreifen (10) eingenommenen Bereichs aufweist, bedeckt ist.

4. Laserdiode nach Anspruch 2 oder 3,
**dadurch gekennzeichnet,**
daß die Spacerschichten (51) aus dem gleichen Halbleitermaterial bestehen wie die Deckschicht (6,6').

5. Laserdiode nach Anspruch 3 oder 4,
**dadurch gekennzeichnet,**
daß die Spacerschichten (5,51) höchstens bis an die Obergrenze des oberen Streifens (4) heranreichen.

6. Laserdiode nach Anspruch 1,
**dadurch gekennzeichnet,**
- daß das Substrat (21,31,41) strukturiert ist, daß unter Ausnutzung der Strukturierung (18,19) dieses Substrats (21,31, 41) eine aktive Schicht (30) in der Weise aufgewachsen ist, daß diese aktive Schicht (30) mit dem aktiven Streifen (3,3'), der längs der Strukturierung (18,19) des Substrates (21,31,41) verläuft, und davon getrennten Seitenbereichen (23,33) ausgebildet ist,
- daß das Halbleitermaterial, daß den aktiven Streifen (3) seitlich begrenzt, Halbleitermaterial der Deckschicht (34, 44,54) ist,
- daß die Deckschicht (34,44,54) aus einem Halbleitermaterial besteht, das von mindestens einem für selektives Ätzen der lateralen Kanäle (80,81,82) verwendbaren Stoff nicht angegriffen wird, und
- daß die lateralen Kanäle (80,81,82) in diesen Seitenbereichen (23,33) der aktiven Schicht (30) ausgebildet sind.

7. Laserdiode nach Anspruch 6,
**dadurch gekennzeichnet,**
daß auf das strukturierte Substrat (31,41) die Pufferschicht (22,32,42), eine aktive Schicht (30) und die Deckschicht (34,44,54) aufgebracht sind,
daß die aktive Schicht (30) als der mindestens eine aktive Streifen (3) auf der Strukturierung (18,19) des Substrates (31,41) und als Seitenbereiche (23,33) ausgebildet ist, wobei die Flanken der Strukturierung (18,19) nicht bedeckt sind, daß seitlich jedes aktiven Streifens (3) laterale Kanäle (80,81,82) bis an die Flanken der Strukturierung (18,19) heranreichend ausgebildet sind,
daß zumindest ein Teil dieser lateralen Kanäle (80,81) nach außen hin durch Stege (7,17) und gegebenenfalls weiterer Flanken von parallel zu dem bzw. den aktiven Streifen (3) verlaufenden Strukturierungen begrenzt sind,
daß die Laserdiode mit einer Deckschicht (34,44,54) planarisiert ist,
daß oberhalb jedes aktiven Streifens (3) ein Kontaktstreifen (10) aufgebracht ist und
daß die Oberfläche des Kontaktstreifens (10) und der Deckschicht (34,44,54) mit einem strukturierten Metallkontakt (11,11'), der mindestens eine Kontaktierfläche (140) außerhalb des von dem Kontaktstreifen (10) eingenommenen Bereiches aufweist, versehen ist.

8. Laserdiode nach Anspruch 6 oder 7,
**dadurch gekennzeichnet,**
daß die Strukturierung des Substrates (21) in mindestens einem Graben (18) besteht.

9. Laserdiode nach Anspruch 6 oder 7,
**dadurch gekennzeichnet,**
daß die Strukturierung des Substrates (31,41) in mindestens einem ridge (19) besteht.

10. Laserdiode nach einem der Ansprüche 1 bis 9,
**dadurch gekennzeichnet,**
daß das Substrat (41) aus einem semiisolierenden Material besteht, daß die Pufferschicht (42) in einem seitlichen, außerhalb des von dem bzw. den laseraktiven Streifen (3) eingenommenen Bereiches liegenden Bereich, der von der Deckschicht (54) frei gelassen wird, mit einem weiteren Metallkontakt (12') versehen ist.

11. Verfahren zur Herstellung einer Laserdiode nach Anspruch 3 oder 4,
**dadurch gekennzeichnet,**
daß folgende Schritte durchgeführt werden:
a) auf eine Grundstruktur, die mindestens ein Substrat (1) und eine Pufferschicht (2) aus einem ersten Halbleitermaterial enthält, wird eine aktive Schicht (30) aufgebracht,
b) auf diese aktive Schicht (30) wird eine obere Schicht (40) aufgebracht,
c) die aktive Schicht (30) und die obere Schicht (40) werden mit Hilfe einer Maske zu einem aktiven Streifen (3) und einem oberen Streifen (4) herabgeätzt,
d) an die Flanken des aktiven Streifens (3) und des oberen Streifens (4) wird ein Halbleitermaterial in Form von Spacerschichten (5) aufgebracht,
e) seitlich der Spacerschichten (5) wird eine Zwischenschicht (13) aufgebracht, die an den Flanken der Spacerschichten (5) mindestens die Dicke des aktiven Streifens (3) aufweist und aus einem Material besteht, das sich mit einer Ätze, die das Halbleitermaterial der Spacerschichten (5,51) nicht angreift, entfernen läßt,
f) auf die Zwischenschicht (13) wird die Deckschicht (64) aufgebracht,
g) auf diese Deckschicht (64) wird eine Kontaktschicht (100) aufgebracht,
h) mit Hilfe einer Maske wird die Kontaktschicht (100) so auf einen Kontaktstreifen (10) herabgeätzt, daß der aktive Streifen (3) im Schatten des Kontaktstreifens (10) liegt,
i) mit Hilfe einer Maske werden in die Deckschicht (64) seitlich des Kontaktstreifens (10) senkrecht zu den Schichten verlaufende transversale Kanäle (9) bis auf die Zwischenschicht (13) geätzt,
j) die Zwischenschicht (13) wird mit einer selektiv wirksamen Ätze bis zu den Spacerschichten (5) weggeätzt, so daß sich laterale Kanäle (8) ergeben,
k) die Laserdiode wird auf der dem Substrat (1) abgewandten Seite mit einem strukturierten Metallkontakt (11) versehen, der den Kontaktstreifen (10) ganz bedeckt, der die transversalen Kanäle (9) offenläßt und der eine Kontaktierung der Laserdiode auf Kontaktierflächen (140) außerhalb des Bereichs des Kontaktstreifens (10) zuläßt.

12. Verfahren nach Anspruch 11,
**dadurch gekennzeichnet,**
daß in Schritt i) als Maske ein strukturierter Metallkontakt (11), der den Kontaktstreifen (10) ganz bedeckt und der eine Kontaktierung der Laserdiode auf Kontaktierflächen (140) außerhalb des Bereichs des Kontaktstreifens (10) zuläßt, verwendet wird und Schritt k) entfällt.

13. Verfahren zur Herstellung einer Laserdiode nach Anspruch 4,
**dadurch gekennzeichnet,**
daß folgende Schritte durchgeführt werden:
a) auf ein Substrat (1) werden eine Pufferschicht (2), eine aktive Schicht (30) und eine obere Schicht (40) aufgebracht,
b) in die obere Schicht (40) und die aktive Schicht (30) werden parallele Gräben (16) bis auf die Pufferschicht (2) so geätzt, daß zwischen diesen parallelen Gräben (16) die aktive Schicht (30) die obere Schicht (40) als aktiver Streifen (3) und oberer Streifen (4) stehenbleiben,
c) die Struktur wird mit einer Deckschicht (74) so überwachsen, daß die parallelen Gräben (16) mit Spacerschichten (51) aufgefüllt werden und daß die Struktur überschichtet wird,
d) auf die Deckschicht (74) wird eine Kontaktschicht (100) aufgebracht,
e) diese Kontaktschicht (100) wird so auf einen Kontaktstreifen (10) herabgeätzt, daß die seitlichen Bereiche der Deckschicht (74) freigelegt werden und daß der aktive Streifen (3) im Schatten dieses Kontaktstreifens (10) liegt,
f) mit Hilfe einer Maske werden in die Deckschicht (74) seitlich des aktiven Streifens (3) außerhalb der Spacerschichten (51) senkrecht zu den Schichten verlaufende, transversale Kanäle (9) bis auf die Seitenbereiche (43) der aktiven Schicht (30) geätzt,
g) diese Seitenbereiche (43) der aktiven Schicht (30) werden mit einer selektiven wirksamen Ätze bis zu den Spacerschichten (51) weggeätzt,
h) die Laserdiode wird auf der dem Substrat (1) abgewandten Seite mit einem strukturierten Metallkontakt (11) versehen, der den Kontaktstreifen (10) ganz bedeckt, der die transversalen Kanäle (9) offenläßt und der eine Kontaktierung der Laserdiode auf Kontaktierflächen (140) außerhalb des Bereichs des Kontaktstreifens (10) zuläßt.

14. Verfahren nach Anspruch 13,
**gekennzeichnet dadurch,**
daß in Schritt f) als Maske ein strukturierter Metallkontakt (11), der den Kontaktstreifen (10) ganz bedeckt und der eine Kontaktierung der Laserdiode auf Kontaktierflächen (140) außerhalb des Bereichs des Kontaktstreifens (10) zuläßt, verwendet wird und Schritt h) entfällt.

15. Verfahren zur Herstellung einer Laserdiode nach einem der Ansprüche 6 bis 9,
**dadurch gekennzeichnet,**
daß folgende Schritte ausgeführt werden:
a) auf ein strukturiertes Substrat (21,31,41) werden nacheinander epitaktisch eine Pufferschicht (22,32,42), eine aktive Schicht (30) und eine Deckschicht (14,24,34,44,54) aufgebracht,
b) die Prozeßparameter beim Aufwachsen der aktiven Schicht (30) werden so gewählt, daß die aktive Schicht (30) nur auf der Struktur und neben der Struktur und nicht auf den Flanken der Struktur aufwächst, so daß dadurch ein aktiver Streifen (3) und Seitenbereiche (23,33) der aktiven Schicht ausgebildet werden,
c) auf die Deckschicht (14,24,34,44,54) wird eine Kontaktschicht aufgebracht,
d) die Kontaktschicht wird so auf einen Kontaktstreifen (10) herabgeätzt, daß die seitlichen Bereiche der Deckschicht (14,24,34,44,54) freigelegt werden und daß der aktive Streifen (3) im Schatten dieses Kontaktstreifens (10) liegt,
e) mit Hilfe einer Maske werden in die Deckschicht (14,24,34, 44,54) senkrecht zum Schichtaufbau außerhalb des aktiven Streifens (3) transversale Kanäle (9) mindestens bis auf die Seitenbereiche (23,33) der aktiven Schicht geätzt,
f) mit einer selektiv wirksamen Ätze, die nur das Material der aktiven Schicht (30) angreift und das Material der Deckschicht (14,24,34,44,54) und der Pufferschicht (22,32, 42) nicht angreift, werden die Seitenbereiche (23,33) der aktiven Schicht geätzt und dadurch laterale Kanäle (80,81, 82) hergestellt,
g) die Laserdiode wird auf der dem Substrat (21,31,41) abgewandten Seite mit einem strukturierten Metallkontakt (11) versehen, der den Kontaktstreifen (10) ganz deckt, der die transversalen Kanäle (9) offenläßt und der eine Kontaktierung der Laserdiode auf Kontaktierflächen (140) außerhalb des Bereichs des Kontaktstreifens (10) zuläßt.

16. Verfahren nach Anspruch 15,
**dadurch gekennzeichnet,**
daß in Schritt e) als Maske ein strukturierter Metallkontakt (11) verwendet wird, der den Kontaktstreifen (10) ganz bedeckt und der eine Kontaktierung der Laserdiode auf Kontaktierflächen (140) außerhalb des Bereichs des Kontaktstreifens (10) zuläßt, und daß Schritt g) entfällt.

17. Laserdiode nach einem der Ansprüche 1 bis 10,
**dadurch gekennzeichnet,**
daß mehrere nebeneinander parallel verlaufende laseraktive Streifen mit jeweils parallel zu diesen verlaufenden lateralen Kanälen vorgesehen sind.

## Claims

1. Laser diode having a buried semi-conductor double heterostructure and lateral current limitation, this laser diode containing at least one laser-active strip (3) between a buffer layer (2,32,42) and a cover layer (6,6',34,44,54), and having metal contacts, and there being provided to the side of the laser-active strip (3) and extending parallel thereto lateral, etched channels (8,8',80,81,82), characterised in that
- the laser-active strip (3) is separated from the lateral channels by laterally arranged semi-conductor material,
- the lateral limitation of the laser-active strip (3) extends as rectilinearly as is possible using semi-conductor layers produced by masking technology.

2. Laser diode according to Claim 1, characterised in that
- the semi-conductor material, which is arranged laterally on the active strip (3), is constructed as spacer layers (5,51),
- the lateral channels (8,8') are constructed in semi-conductor material that is grown laterally outwards, bordering on these spacer layers (5,51), and
- the spacer layers (5,51) comprise semi-conductor material which is not attacked by at least one substance which can be used for selective etching of the lateral channels (8,8').

3. Laser diode according to Claim 2, characterised in that the at least one active strip (3), and thereon an upper strip (4), are applied to a basic structure which contains at least one substrate (1) and the buffer layer (2) made from a first semi-conductor material, in that there are applied to the side walls of each active strip (3) and of the associated upper strip (4), spacer layers (5,51) which in each case completely cover the side walls of the active strip (3), in that lateral channels (8,8') are constructed laterally bordering on the spacer layers (5), and extending parallel to the active strip (3), in that these lateral channels (8, 8') are limited on the outside by webs (7), in that the laser diode is planarised by the cover layer (6,6'), in that a contact strip (10) is applied above the active strip (3), and in that the surface of this contact strip (10) and of the cover layer (6, 6') is covered by a structured metal contact (11) which has at least one contacting surface (140) outside the region occupied by the contact strip (10).

4. Laser diode according to Claim 2 or 3, characterised in that the spacer layers (51) comprise the same semi-conductor material as the cover layer (6, 6').

5. Laser diode according to Claim 3 or 4, characterised in that the spacer layers (5,51) reach at most up to the upper boundary of the upper strip (4).

6. Laser diode according to Claim 1, characterised in that
- the substrate (21,31,41) is structured, in that by utilising the structuring (18,19) of this substrate (21,31,41) an active layer (30) is grown in such a way that this active layer (30) is constructed by the active strip (3,3'), which extends along the structuring (18,19) of the substrate (21,31,41), and lateral regions (23,33) separated therefrom,
- the semi-conductor material which laterally limits the active strip (3) is semi-conductor material of the cover layer (34,44,54),
- the cover layer (34,44,54) comprises a semi-conductor material which is not attacked by at least one substance that can be used for selective etching of the lateral channels (80,81,82), and
- the lateral channels (80,81,82) are constructed in these lateral regions (23,33) of the active layer (30).

7. Laser diode according to Claim 6, characterised in that the buffer layer (22,32,42), an active layer (30) and the cover layer (34,44,54) are applied to the structured substrate (31,41), in that the active layer (30) is constructed as the at least one active strip (3) on the structuring (18,19) of the substrate (31,41) and as lateral regions (23,33), the side walls of the structuring (18,19) not being covered, in that lateral channels (80,81,82) are constructed to the side of each active strip (3) so as to reach up to the side walls of the structuring (18,19), in that at least some of these lateral channels (80,81) are limited towards the outside by webs (7,17) and, if necessary, by further side walls of structurings extending parallel to the active strip/strips (3), in that the laser diode is planarised by a cover layer (34,44,54), in that a contact strip (10) is applied above each active strip (3) and, in that the surface of the contact strip (10) and of the cover layer (34,44,54) is provided with a structured metal contact (11,11') which has at least one contacting surface (140) outside the region occupied by the contact strip (10).

8. Laser diode according to Claim 6 or 7, characterised in that the structuring of the substrate (21) comprises at least one trench (18).

9. Laser diode according to Claim 6 or 7, characterised in that the structuring of the substrate (31,41) comprises at least one ridge (19).

10. Laser diode according to one of Claims 1 to 9, characterised in that the substrate (41) comprises a semi-insulating material, and in that the buffer layer (42) is provided with a further metal contact (12') in a lateral region which is located outside the region occupied by the laser-active strip/strips (3) and which is left free by the cover layer (54).

11. Method of producing a laser diode according to Claim 3 or 4, characterised in that the following steps are carried out:
a) an active layer (30) is applied to a basic structure which contains at least one substrate (1) and a buffer layer (2) made from a first semi-conductor material,
b) an upper layer (40) is applied to this active layer (30),
c) the active layer (30) and the upper layer (40) are etched down with the aid of a mask to an active strip (3) and an upper strip (4),
d) a semi-conductor material is applied in the form of spacer layers (5) to the side walls of the active strip (3) and of the upper strip (4),
e) an intermediate layer (13) is applied to the side of the spacer layers (5) which has at the side walls of the spacer layers (5) at least the thickness of the active strip (3) and comprises a material which can be removed by an etching solution which does not attack the semi-conductor material of the spacer layers (5,51),
f) the cover layer (64) is applied to the intermediate layer (13),
g) a contact layer (100) is applied to this cover layer (64),
h) the contact layer (100) is etched down with the aid of a mask to a contact strip (10) in such a way that the active strip (3) is situated in the shadow of the contact strip (10),
i) transverse channels (9) extending perpendicular to the layers are etched with the aid of a mask into the cover layer (64) to the side of the contact strip (10) as far as the intermediate layer (13),
j) the intermediate layer (13) is etched away by a selectively active etching solution as far as the spacer layers (5), so that lateral channels (8) are produced,
k) the laser diode is provided on the side averted from the substrate (1) with a structured metal contact (11) which completely covers the contact strip (10), which leaves the transverse channels (9) open and which permits contacting of the laser diode on contacting surfaces (140) outside the region of the contact strip (10).

12. Method according to Claim 11, characterised in that in step i) a structured metal contact (11) is used as the mask, completely covers the contact strip (10) and permits contacting of the laser diode on contacting surfaces (140) outside the region of the contact strip (10), and step k) is omitted.

13. Method of producing a laser diode according to Claim 4, characterised in that the following steps are carried out:
a) a buffer layer (2), an active layer (30) and an upper layer (40) are applied to a substrate (1),
b) parallel trenches (16) are etched into the upper layer (40) and the active layer (30) as far as the buffer layer (2) in such a way that between these parallel trenches (16) the active layer (30) and the upper layer (40) are left as an active strip (3) and an upper strip (4),
c) the structure has a cover layer (74) grown over it in such a way that the parallel trenches (16) are filled up with spacer layers (51) and that the structure is coated,
d) a contact layer (100) is applied to the cover layer (74),
e) this contact layer (100) is etched down to a contact strip (10) in such a way that the lateral regions of the cover layer (74) are exposed and that the active strip (3) is situated in the shadow of this contact strip (10),
f) transverse channels (9) extending perpendicular to the layers are etched with the aid of a mask into the cover layer (74) to the side of the active strip (3) outside the spacer layers (51) as far as the lateral regions (43) of the active layer (30),
g) these lateral regions (43) of the active layer (30) are etched away by a selective, active etching solution as far as the spacer layers (51),
h) the laser diode is provided on the side averted from the substrate (1) with a structured metal contact (11) which completely covers the contact strip (10), which leaves the transverse channels (9) open and which permits contacting of the laser diode on contacting surfaces (140) outside the region of the contact strip (10).

14. Method according to Claim 13, characterised in that in step f) a structured metal contact (11) is used as the mask, completely covers the contact strip (10) and permits contacting of the laser diode on contacting surfaces (140) outside the region of the contact strip (10), and step h) is omitted.

15. Method of producing a laser diode according to one of Claims 6 to 9, characterised in that the following steps are carried out:
a) a buffer layer (22,32,42), an active layer (30) and a cover layer (14,24,34,44,54) are successively applied epitaxially to a structured substrate (21,31,41),
b) the process parameters in the growth of the active layer (30) are selected in such a way that the active layer (30) grows only on the structure and next to the structure and not on the side walls of the structure, so that an active strip (3) and lateral regions (23,33) of the active layer are constructed as a result,
c) a contact layer is applied to the cover layer (14,24,34,44,54),
d) the contact layer is etched down to a contact strip (10) in such a way that the lateral regions of the cover layer (14,24,34,44,54) are exposed and that the active strip (3) is situated in the shadow of this contact strip (10 ,
e) transverse channels (9) are etched with the aid of a mask into the cover layer (14,24,34,44,54) perpendicular to the layer structure outside the active strip (3) at least as far as the lateral regions (23,33) of the active layer,
f) a selectively active etching solution which attacks only the material of the active layer (30) and does not attack the material of the cover layer (14,24,34,44,54) and of the buffer layer (22,32,42) is used to etch the lateral regions (23,33) of the active layer and thus to produce lateral channels (80,81,82),
g) the laser diode is provided on the side averted from the substrate (21,31,41) with a structured metal contact (11) which completely covers the contact strip (10), which leaves the transverse channels (9) open and which permits contacting of the laser diode on contacting surfaces (140) outside the region of the contact strip (10).

16. Method according to Claim 15, characterised in that in step e) a structured metal contact (11) is used as the mask, completely covers the contact strip (10) and permits contacting of the laser diode on contacting surfaces (140) outside the region of the contact strip (10), and step g) is omitted.

17. Laser diode according to one of Claims 1 to 10, characterised in that a plurality of laser-active strips extending parallel next to one another are provided with lateral channels each extending parallel to said strips.

## Revendications

1. Diode laser comportant une double hétérostructure semiconductrice ensevelie et à limitation latérale du courant, cette diode laser comportant au moins une bande (3) active pour l'effet laser et située entre une couche tampon (2,32,42) et une couche de revêtement (6,6',34, 44,54), et possédant des contacts métalliques, et dans laquelle il est prévu des canaux latéraux (8,8',80,81,82) formés par corrosion qui s'étendent latéralement par rapport à la bande (3) active pour l'effet laser et sont parallèles à cette dernière,
caractérisée par le fait
- que la bande (3) active pour l'effet laser est séparée des canaux latéraux par un matériau semiconducteur disposé latéralement, et
- que la limitation latérale de la bande (3) active pour l'effet laser est rectiligne, comme cela est possible dans le cas de couches semiconductrices fabriquées en utilisant une technique de masques.

2. Diode laser suivant la revendication 1, caractérisée par le fait
- que le matériau semiconducteur, qui est disposé latéralement à côté de la bande active (3), est agencé sous la forme de couches-entretoises (5,51), et
- que les canaux latéraux (8,8') sont formés dans le matériau semiconducteur formé par croissance de manière à jouxter latéralement et extérieurement ces couches-entretoises (5,51), et
- que les couches-entretoises (5,51) sont réalisées en un matériau semiconducteur, qui n'est pas attaqué par au moins une substance pouvant être utilisée pour la corrosion sélective des canaux latéraux (8,8').

3. Diode laser suivant la revendication 2, caractérisée par le fait
que sur une structure de base, qui comporte au moins un substrat (1) et la couche tampon (2) formée d'un premier matériau semiconducteur, on dépose au moins une bande active (3) et, sur cette dernière, une autre bande (4),
que sur les flancs de chaque bande active (3) et de la bande supérieure associée (4) on dépose des couches-entretoises (5,51), qui recouvrent respectivement complètement les flancs de la bande active (3),
qu'on forme des canaux latéraux (8,8') qui sont parallèles à la bande active (3) et jouxtent latéralement les couchesentretoises (5),
qu'on limite vers l'extérieur ces canaux latéraux (8,8') par des barrettes (7),
qu'on planarise la diode laser avec la couche de revêtement (6,6'), et
qu'on dépose une bande de contact (10) au-dessus de la bande active (3), et
qu'on recouvre la surface de cette bande de contact (10) et la couche de revêtement (6,6') par un contact métallique structuré (11), qui possède au moins une surface de contact (140) à l'extérieur de la zone occupée par la bande de contact (10).

4. Diode laser suivant la revendication 2 ou 3, caractérisée par le fait que les couches-entretoises (52) sont constituées du même matériau semiconducteur que la couche de revêtement (6,6').

5. Diode laser suivant la revendication 3 ou 4, caractérisée par le fait que les couches-entretoises (5,51) s'étendent au maximum jusqu'au niveau de la limite supérieure de la bande supérieure (4).

6. Diode laser suivant la revendication 1, caractérisée par le fait
- que le substrat (21,31,41) est structuré de telle sorte que moyennant la structuration (18,19) de ce substrat (21,31,41), on obtient la croissance d'une couche active (30) de telle sorte
que cette couche active (30) est formée avec la couche active (3,3'), qui s'étend le long de la structuration (18, 19) du substrat (21,31,41), et par des zones latérales (23,33) separées de cette bande,
- que le matériau semiconducteur, qui limite latéralement la bande active (3), est le matériau semiconducteur de la couche de revêtement (34,44,54),
- que la couche de revêtement (34,44,54) est constituée par un matériau semiconducteur, qui n'est pas attaqué par au moins une substance utilisable pour la corrosion sélective des canaux latéraux (80,81,82), et
- que les canaux latéraux (80,81,82) sont formés dans ces parties latérales (23,33) de la couche active (30).

7. Diode laser suivant la revendication 6, caractérisée par le fait
que sur le substrat structuré (31,41) on dépose la couche tampon (22,32,42), une couche active (30) et la couche de revêtement (34,44,54),
que la couche active (30) est réalisée sous la forme d'au moins une bande active (30) sur la partie structurée (18,19) du substrat (31,41) et sous la forme de zones latérales (23,33), les flancs de la partie structurée (18,19) n'étant pas recouverts,
que des canaux latéraux (80,81,82) sont formés latéralement par rapport à chaque bande active (3) de manière à s'étendre jusqu'aux flancs de la partie structurée (18,19),
qu'au moins une partie de ces canaux latéraux (80,81) Sont limités vers l'extérieur par des barrettes (16,17) et éventuellement par d'autres flancs de parties structurées parallèles à la ou aux bandes actives (3),
que la diode laser pourvue d'une couche de revêtement (34,44, 54) est planarisée,
qu'une bande de contact (10) est déposée au-dessus de chaque bande active (3), et
que la surface de la bande de contact (10) et de la couche de revêtement (34,44,54) est équipée d'un contact métallique structuré (11,11'), qui possède au moins une surface de contact (140) à l'extérieur de la zone occupée par la bande de contact (10).

8. Diode laser suivant la revendication 6 ou 7, caractérisée par le fait que la partie structurée du substrat (21) se compose au moins d'un sillon (18).

9. Diode laser suivant la revendication 6 ou 7, caractérisée par le fait que la partie structurée du substrat (31,41) est constituée par au moins une nervure (19).

10. Diode laser suivant l'une des revendications 1 à 9, caractérisée par le fait
que le substrat (41) est constitué par un matériau semi-isolant, et
que la couche tampon (42) est pourvue d'un autre contact métallique (12') dans une zone latérale, qui est située à l'extérieur de la zone occupée par la ou les bandes (3) actives pour l'effet laser et est laissée nue par la couche de revêtement (54).

11. Procédé pour fabriquer une diode laser suivant la revendication 3 ou 4,
caractérisé par le fait
qu'on met en oeuvre les étapes suivantes :
a) sur une structure de base qui comporte au moins un substrat (1) et une couche tampon (2) formée d'un premier matériau semiconducteur, on dépose une couche active (30),
b) sur cette couche active (30), on dépose une couche supérieure (40),
c) on élimine par corrosion la couche active (30) et la couche supérieure (40), en utilisant un masque, jusqu'à l'obtention d'une bande active (3) et une bande supérieure (4),
d) sur les flancs de la bande active (3) et de la bande supérieure (4), on dépose un matériau semiconducteur sous la forme de couches-entretoises (5),
e) latéralement par rapport aux couches-entretoises (5), on dépose une couche intercalaire (13), qui possède, au niveau des flancs des couches-entretoises (5), au moins l'épaisseur de la bande active (3) et est réalisée en un matériau que l'on peut éliminer au moyen d'un agent corrosif qui n'attaque pas le matériau semiconducteur des couches-entretoises (5,51),
f) sur la couche intercalaire (13), on dépose la couche de revêtement (64),
g) sur cette couche de revêtement (64), on dépose une couche de contact (100),
h) à l'aide d'un masque, on élimine par corrosion la couche de contact (100) hormis une bande de contact (10) de sorte que la bande active (3) se situe aux limites de la projection de la bande de contact (10),
i) à l'aide d'un masque on forme latéralement par rapport à la bande de contact (10), dans la couche de revêtement (64), des canaux transversaux (9) qui sont perpendiculaires aux couches en laissant subsister la couche intercalaire (13),
j) on élimine par corrosion la couche intercalaire (13) au moyen d'un agent corrosif à action sélective en laissant subsister les couches-entretoises (5) de sorte qu'on obtient des canaux latéraux (8),
k) on applique à la diode laser, sur la face tournée à l'opposé du substrat (1), un contact métallique structuré (11), qui recouvre complètement la bande de contact (10) qui laisse ouverts les canaux transversaux (9) et permet l'établissement d'un contact avec la diode laser sur des surfaces de contact (140) à l'extérieur de la zone de la bande de contact (10).

12. Procédé suivant la revendication 11, caractérisé par le fait que lors de l'étape i), comme masque, on utilise un contact métallique structuré (11) qui recouvre complètement la bande de contact (10) et permet l'établissement d'un contact de la diode laser sur des surfaces de contact (140) à l'extérieur de la zone de la bande de contact (10), et on supprime l'étape k).

13. Procédé pour fabriquer une diode laser suivant la revendication 4, caractérisé par le fait qu'on exécute les étapes suivantes :
a) sur un substrat (1), on dépose une couche tampon (2), une couche active (30) et une couche supérieure (40),
b) dans la couche supérieure (40) et dans la couche active (30), on forme par corrosion des sillons parallèles (16) jusqu'à la couche tampon (2) de sorte qu'entre ces sillons parallèles (16) subsistent la couche active (30), la couche supérieure (40) en tant que bande active (30) et bande supérieure (4),
c) on fait croître sur la structure une couche de revêtement (74) de manière que les sillons parallèles (16) soient remplis par des couches-entretoises (51) et que la structure soit recouverte,
d) sur la couche de revêtement (74), on dépose une couche de contact (100),
e) on élimine par corrosion cette couche de contact (100) hormis une bande de contact (10) de telle sorte que les zones latérales de la couche de revêtement (74) sont mises à nu et que la bande active (30) est située dans les limites de la projection horizontale de cette bande de contact (10),
f) à l'aide d'un masque, on forme latéralement par rapport à la bande active (3), dans la couche de revêtement (74) et à l'extérieur des couches-entretoises (51), des canaux transversaux (9) perpendiculaires aux couches, hormis dans les zones latérales (43) de la couche active (30),
g) on élimine par corrosion ces zones latérales (43) de la couche active (30) en utilisant un agent corrosif actif de façon sélective, jusqu'aux couches-entretoises (51),
h) on équipe la diode laser, sur la face tournée à l'opposé du substrat (1), d'un contact métallique structuré (11), qui recouvre complètement la bande de contact (10), laisse ouverts les canaux transversaux (9) et permet l'établissement d'un contact de la diode laser sur des surfaces de contact (140) à l'extérieur de la zone de la bande de contact (10).

14. Procédé msuivant la revendication 13, caractérisé par le fait que lors de l'étape f), comme masque, on utilise un contact métallique structuré (11) qui recouvre complètement la bande de contact (10) et permet l'établissement d'un contact de la diode laser sur des surfaces de contact (140) à l'extérieur de la zone de la bande de contact (10), et on supprime l'étape k).

15. Procédé pour fabriquer une diode laser suivant l'une des revendications 6 à 9, caractérisé par le fait qu'on exécute les étapes suivantes
a) sur un substrat structuré (21,31,41), on dépose successivement par épitaxie une couche tampon (22,32,42), une couche active (30) et une couche de revêtement (14,24,34,44,54),
b) on choisit les paramètres du processus lors de la croissance de cette couche active (30) de telle sorte que la couche active (30) est formée par croissance uniquement à côté de la structure et pas sur les flancs de la structure de sorte que l'on forme ainsi une bande active (3) et des zones latérales (23,33) de la couche active,
c) sur la couche de revêtement (14,24,34,44,54), on dépose une couche de contact,
d) on élimine par corrosion cette couche de contact en laissant subsister une bande de contact (10) de telle sorte que les zones latérales de la couche de revêtement (14,24,34,44,54) sont mises à nu et que la bande active (3) est située dans les limites de la projection de cette bande de contact (10),
e) à l'aide d'un masque, on forme par corrosion, dans la couche de revêtement (14,24,34,44,54), perpendiculairement à la structure des couches et à l'extérieur de la bande active (3), des canaux transversaux (9) au moins jusqu'au niveau des zones latérales (23,33) de la couche active,
f) en utilisant un agent corrosif à action sélective, qui attaque uniquement le matériau de la couche active (30) et n'attaque pas le matériau de la couche de revêtement (14,24,34,44,54) et de la couche tampon (22,32,42), on élimine par corrosion les zones latérales (23,33) de la couche active et on forme de ce fait des canaux latéraux (80,81,82),
g) on équipe la diode laser, sur la surface tournée à l'opposé du substrat (21,31,41), d'un contact métallique structuré (11), qui recouvre complètement la bande de contact (10) qui laisse ouverts les canaux transversaux (9) et autorise l'établissement d'un contact avec la diode laser sur des surfaces de contact (140) à l'extérieur de la zone de la bande de contact (10).

16. Procédé suivant la revendication 15, caractérisé par le fait
que lors de l'étape e), on utilise comme masque un contact métallique structuré (11), qui recouvre complètement la bande de contact (10) et qui permet l'établissement d'un contact avec la diode laser sur des surfaces de contact (140) à l'extérieur de la zone de la bande de contact (10), et qu'on supprime l'étape g).

17. Diode laser suivant l'une des revendications 1 à 10, caractérisée par le fait qu'on prévoit plusieurs bandes parallèles actives pour l'effet laser, disposées côte-à-côte et comportant des canaux latéraux qui s'étendent respectivement parallèlement à ces bandes.
